Europäisches Patentamt

European Patent Office

Office européen des brevets

(11) Publication number: **0 204 724**
**B1**

## EUROPEAN PATENT SPECIFICATION

(45) Date of publication of patent specification: **24.01.90**

(21) Application number: **85905584.0**

(22) Date of filing: **01.11.85**

(86) International application number:
**PCT/US85/02173**

(87) International publication number:
**WO 86/03228 05.06.86 Gazette 86/12**

(51) Int. Cl.5: **C 23 C 16/30** // C23C16/48, H01L21/205

(54) **METHOD FOR DEPOSITION OF GALLIUM ARSENIDE FROM VAPOR PHASE GALLIUM-ARSENIC COMPLEXES.**

(30) Priority: **20.11.84 US 673497**

(43) Date of publication of application:
**17.12.86 Bulletin 86/51**

(45) Publication of the grant of the patent:
**24.01.90 Bulletin 90/04**

(84) Designated Contracting States:
**DE FR GB**

(56) References cited:
EP-A-0 052 979
DE-A-2 703 873
FR-A-2 403 646

Electronics Letters, vol. 19, no. 18, 1 September 1983 P. Speier: " In x Ga (1-x) As epitaxy with metalorganic adducts ", pages 728,729, see the whole article

Patents Abstracts of Japan, vol. 8, no. 123, (E-249) (1560), 8 June 1984 & JP A 5934628

(73) Proprietor: **Hughes Aircraft Company**
**7200 Hughes Terrace P.O. Box 45066**
**Los Angeles, California 90045-0066 (US)**

(72) Inventor: **JENSEN, John, E.**
**3609 Pebble Place**
**Newbury Park, CA 91320 (US)**
Inventor: **OLSON, Gregory, L.**
**27526 Rondell Street**
**Agoura, CA 91301 (US)**

(74) Representative: **Kuhnen, Wacker & Partner**
**Schneggstrasse 3-5 Postfach 1553**
**D-8050 Freising (DE)**

(56) References cited:
Electronic Letters,vol.19 , no. 4, February 1983 W.Roth: " Fast photoconductive GaAs detectors made by laser stimulated MOCVD ", pages 142,143, see the whole article

Journal of Crystal Growth, vol. 55, no. 1, October 1981 A.Zaouk : " Various chemical mechanisms for the crystal growth of III-V semiconductors using coordination compounds as starting material in the MOCVD process "

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to a method for depositing GaAs on a substrate according to claim 1.

This patent application is related to US—A—4,594,264.

US—A—4,594,264 discloses a method for forming thin solid films of certain gallium-arsenic complexes on suitable substrates and then photochemically converting the films to GaAs by irradiation with ultraviolet light. The complexes which are utilized in this method include gallium-arsenic complexes having the formula $X_3GaAsR_3$, where X is chlorine, bromine, iodine, phenyl, methyl or trifluoromethyl and R is hydrogen, phenyl, benzyl, methyl or trifluoromethyl.

There has been an increasing demond for pure high quality gallium arsenide which is suitable for use in fabricating electronic and opto-electronic devices, as well as solar cells. Accordingly, there has been a great deal of interest in developing simple, effective and reliable techniques for producing high quality gallium arsenide.

Most of the methods presently being used to grow ultra-pure gallium arsenide are either based upon bulk crystal growth processes or epitaxial techniques. The bulk crystal growth processes are generally based upon the Czochralski or Bridgman methods. Both of these methods basically involve heating a mixture of gallium and arsenic to form a melt of gallium arsenide. A seed crystal is then dipped into the melt. The seed is allowed to melt back a short distance to remove any surface imperfections which may result from its preparation. The seed crystal is then slowly withdrawn from the melt. The rate of seed crystal withdrawal and melt temperature are closely controlled so that a single pure crystal of gallium asrsenide is pulled from the melt. This type of bulk crystal growing technique has widely been used for growing various other crystals and the numerous disadvantages of this technique are well documented.

Both liquid phase and gas phase epitaxy have been used in the past to deposit thin films of pure gallium arsenide on bulk gallium arsenide wafers or other substrates. In general, these epitaxial techniques have involved either chemical or thermal treatment of gallium arsenide and gallium arsenide precursors present in the gas or liquid phase to form gallium arsenide which is deposited as a thin ultra-pure film on the gallium arsenide susbstrate. In addition, molecular beam epitaxy has been utilized in growing gallium arsenide crystals. Molecular beam epitaxy basically involves heating gallium metal and arsenic metal to high temperatures in order to form gallium and arsenic atoms. The metal atoms are transmitted to the surface of a bulk gallium arsenide wafer to form thin films of ultra-pure gallium arsenide.

The presently available methods for growing ultra-pure gallium arsenide are well suited for their intended purpose; however, none of the presently available methods have been entirely successful commercially. This lack of commerical success is due in part to various different problems which are inherent in the presently available methods.

In accordance with the present invention, a method is provided for photochemically converting gallium-arsenic complexes in the vapor phase into GaAs for direct deposition onto substrates.

The present invention is based on the discovery that certain gallium-arsenic complexes form vapors which can be photochemically converted to GaAs for deposition on a suitable substrate. The photochemical conversion is accomplished by irradiating the vapor phase gallium-arsenic complex adjacent the substrate with ultraviolet light of sufficient wavelength and intensity to convert the gallium-arsenic complex into GaAs.

Gallium-arsenic complexes which form vapors at relatively low temperatures without decomposing and which are suitable for use in accordance with the present invention include those having the formula $X_3GaAsR_3$, where X is methyl or trifluoromethyl and R is hydrogen, methyl or trifluoromethyl.

The method basically involves placing the substrate into a deposition zone which has a substantially moisture- and oxygen-free atmosphere. A vapor consisting of one or more of the above-mentioned gallium-arsenic complexes in vapor form is introduced into the deposition zone to provide contact between the substrate and the vapor phase gallium-arsenic complex. The complex is irradiated in the deposition zone with ultraviolet light of sufficient wavelength and of a sufficient intensity at or near said substrate surface to photochemically convert said gallium-arsenic complex in said vapor to gallium arsenide to thereby provide deposition of gallium arsenide on said substrate surface.

The method in accordance with the present invention provides a useful technique for depositing high quality, pure GaAs onto substrates by a direct deposition from vapor phase complexes. The method is an improvement over the complicated and time consuming conventional methods for growing GaAs.

The above described and many other features and attendant advantages of the present invention will become apparent as the invention becomes better understood by reference to the following detailed description.

Preferred embodiments of the new method are disclosed and claimed in subclaims 2 to 16.

The present invention is directed broadly to a method for depositing and growing thin films of GaAs on a wide variety of substrates. Suitable substrates include Si, Ge, $SiO_2$, $Al_2O_3$, GaAs, ceramics and other conventional substrates which are compatible with GaAs.

The present invention has particular application to growing ultra-pure GaAs by epitaxial type growth on a suitable substrate. Accordingly, a preferred substrate is bulk grade GaAs wafers which are generally employed in epitaxial type growth of GaAs in conventional growth processes. In addition, the method is also useful in depositing thin films of GaAs on Ge and Si substrates during the fabrication of microelectronic circuit structures. Silicon and germanium are also preferred substrates. The substrate is not particularly crctical so long as the GaAs is compatible with the substrate.

The method is basically a photochemical vapor deposition process (photo-CVD). Photo-CVD processes are well-known for use in depositing a wide variety of compounds. Equipment and techniques commonly used in photo-CVD processes are therefore applicable to the present method. The substrate may be heated if desired during the method to a temperature up to as high as 400°C. At temperatures above 400°C, thermal decomposition of the complexes occurs on the substrate as opposed to the desired photo-CVD deposition.

The first step in the method involves placing the substrate into a gas cell, bell jar or other container commonly used in photo-CVD methods. The container defines a deposition zone into which the substrate is placed so that the pressure in the deposition zone ranges from about $1.33 \times 10^{-4}$ to $1.33 \times 10^{-6}$ Pa. The vacuum should be sufficient so that the atmosphere in the deposition zone is substantially moisture and oxygen-free. Once the deposition zone is evacuated to the desired pressure, a gas or vapor consisting of a volatile gallium-arsenic complex is introduced into the deposition zone. The amount of complex-containing gas introduced is typically such that the pressure in the deposition zone is on the order of from $1.33 \times 10^{-2}$ Pa to atmospheric pressure after addition of the gas. The gaseous complex may be added as a batch or on a continous basis as is typically done in other conventional photo-CVD processes.

The volatile gallium-arsenic complexes which may be used include those complexes having the formula $X_3GaAsR_3$, where X is methyl or trifluoromethyl and R is hydrogen, methyl or trifluoromethyl. Complexes where X is chlorine, bromine or iodine are not suitable, since these complexes tend to decompose rapidly when vaporized. Complexes where X or R is phenyl or benzyl are also not suitable since these complexes tend to vaporize at relatively high temperatures and are also unstable when vaporized.

An exemplary preferred compound is one where both X and R are methyl. This complex is commercially available from Alpha Ventron, Inc. (Danvers, MA). It can also be made by combining $(CH_3)_3Ga$ with $As(CH_3)_3$, both of which are available commercially. The combination of these two precursors is preferably carried out in a vaccum system according to well-known techniques. The melting point for $(CH_3)_3Ga$ is 15.8°C, with the boiling point being approximately 55°C. The boiling point for $As(CH_3)_3$ is approximately 50—52°C. Preferably, the two precursors are added to the vacuum system as liquids, i.e., at a temperature below about 50°C. The liquids are then heated to form gases which are combined and react to form the desired $(CH_3)_3GaAs(CH_3)_3$ complex. Any excess reactant or precursor is distilled from the vacuum system, with the final complex being recovered according to conventional techniques. Other preferred exemplary complexes include those where X is trifluoromethyl and R is methyl; where X is trifluoromethyl and R is hydrogen; and where X is methyl and R is hydrogen.

Exemplary synthesis of the above preferred complexes are as follows:

(1) Preparation of Tris(trifluoromethyl)-gallium-trimethylarsine complex, $(CF_3)_3GaAs(CH_3)_3$:
This complex can be prepared by combining $(CF_3)_3Ga$ and $As(CH_3)_3$ in a vacuum line using a standard vacuum line technique similar to that discussed above. The $(CF_3)_3Ga$ can be synthesized by the method of Lagow (U.S. Patent 3,992,424) for preparing other trifluoromethyl-substituted metal compounds.

(2) Tris(trifluoromethyl)gallium-arsine complex, $(CF_3)_3GaAsH_3$:
This complex can be prepared by combining $(CF_3)_3Ga$ and $AsH_3$ in a vacuum line using the same standard vacuum line techniques as those previously mectioned. Since $AsH_3$ has a melting point of $-87°C$ and a boiling point well below room temperature, it is typically introduced into the vacuum line as a gas instead of a liquid, as is the case with preparation of the other precursor complexes. Again, the unreacted $(CF_3)_3Ga$ and/or $AsH_3$ remaining after combination and reaction is distilled from the system due to differences in vapor pressure between the reactants and the complex product. The final product is then recovered from the system.

(3) Trimethyl gallium-arsine complex, $(CH_3)_3GaAsH_3$:
This complex can be prepared similar to (2) above, using $(CH_3)_3Ga$ and $AsH_3$.

The next step in the method of the present invention involves irradiating the gaseous complex within the deposition zone to photochemically convert the complex to GaAs for deposition on the substrate. Irradiation is preferably carried out in a manner similar to other photo-CVD processes using ultraviolet light (UV) as the radiation source. The UV light is typically introduced into the deposition zone through suitable transparent windows in the container. However, any of the known photo-CVD configurations for irradiating the vapor reactant in the deposition zone may be used so long as the gaseous complex at or near the substrate surface is irradiated with a sufficiently intense beam of light at a sufficient wavelength to photochemically convert the gallium-arsenic complex to GaAs.

The preferred radiation sources are lasers such as a pulsed krypton fluoride (KrF) excimer laser, which produces pulsed high intensity ultraviolet radiation having a wavelength of 249 nm. Other suitable lasers include a pulsed argon fluoride (ArF) excimer laser (193 nm) or a frequency doubled argon ion laser (257 nm). Other suitable ultraviolet radiation sources may be used so long as they provide wavelengths in the range of 190 nm to 260 nm and are capable of generating radiation which is sufficiently intense to provide the desired photochemical conversion of the gallium-arsenic complexes within a reasonable time. Preferably, the laser beam is directed normal to the substrate. This is typical of the other photo-CVD processes. If desired the laser beam may also be directed parallel to the substrate surface. When the laser beam is positioned parallel to the substrate surface, the beam must be sufficiently close to the substrate surface so that the photochemically converted gallium-arsenic complexes can migrate to the substrate surface for deposition. If the beam is positioned too far away from the substrate surface, the converted complexes may interact with each other prior to deposition to form undesirable micro droplets of GaAs at locations displaced away from the substrate surface.

The temperature in the deposition zone is not particularly critical so long as the gallium-arsenic complex being photochemically converted for deposition is maintained as a vapor. Temperatures between approximately 50° and 200°C are preferred, with temperatures ranging from about room temperature up to 400°C being acceptable. However, as mentioned above with regards to heating of the substrate, at temperature near or above 400°C, the complexes begin to thermally decompose. This results in undesirable thermal deposition instead of photochemical deposition.

The concentration of gaseous gallium-arsenic complex in the deposition zone and the intensity and duration of radiation can all be varied to provide deposition of the desired thickness of GaAs on the substrate. Preferably, the conditions will be chosen such that GaAs films ranging from about 0.01 to 25 micrometers in thickness will be deposited.

Examples of practice are as follows:

A germanium <100> substrate was positioned in a standard gas cell having UV transparent windows. The substrate was positioned so that its surface was perpendicular to the beam of a kypton fluoride (KrF) excimer laser, having a wavelength of 249 nm, which was passed through the transparent windows.

After placing the substrate in the gas cell the cell was evacuated to $4 \times 10^{-4}$ Pa and filled with the complex $(CH_3)_3GaAs(CH_3)_3$ to a pressure of about 700 Pa. The deposition was then accomplished by pulsed laser irradiation. Pulses were delivered at 10 Hz with a pulse energy of 300 mJ and energy density of 75 mJ/cm$^2$. The deposited film thickness was found to be a function of the number of laser pulses. For this example, the film thickness was measured to be 80 nm for 3600 pulses. In another example in which 100 pulses were incident on the germanium substrate at 2 Hz pulse rate, the measured film thickness was 25 nm.

The above two films resulting from the deposition were examined by ESCA (Electron Spectroscopy for Chemical Analysis) which indicated that stoichiometric GaAs had been deposited and that the chemical bonding in the deposited film is identical to that of a GaAs reference wafer. Also, results of electron chanelling measurements indicate that the film is either polycrystalline or amorphous. It is anticipated that optimization of the method will produce epitaxial films.

Having thus described exemplary embodiments of the present invention, it should be noted by those skilled in the art that the within disclosures are exemplary only and that various other alternatives, adaptations and modifications may be made within the scope of the present invention. Accordingly, the present invention is not limited to the specific embodiments as illustrated herein, but is only limited by the following claims.

## Claims

1. A method for depositing GaAs on a substrate surface comprising the steps of:

placing said substrate in an environment having an atmosphere which is substantially free of moisture and oxygen;

contacting said substrate with a vapor consisting of a volatile gallium arsenic complex selected from the group of complexes having the formula $X_3GaAsR_3$, where X is methyl or trifluoromethyl, and R is hydrogen, methyl, or trifluoromethyl such that said vapor contacts the substrate which may be heated to a temperature not exceeding 400°C so as to prohibit thermal decomposition of the complex; and

irradiating said vapor with ultraviolet light of sufficient wavelength and a sufficient intensity at or near said substrate surface to photochemically convert said gallium-arsenic complex in said vapor to gallium arsenide to thereby provide deposition of gallium arsenide on said substrate surface.

2. The method according to Claim 1, wherein X is methyl.

3. The method according to Claim 2 where R is methyl.

4. The method according to Claim 2 where is trifluoromethyl.

5. The method according to Claim 2 where R is hydrogen.

6. The method according to Claim 1 where X is trifluoromethyl.

7. The method according to Claim 6, where R is hydrogen.

8. The method according to Claim 6 where R is methyl.

9. The method according to Claim 1 where R is hydrogen.

10. The method according to Claim 1 where R is methyl.

11. The method according to Claim 1 where R is trifluoromethyl.

12. The method according to Claim 1 wherein the pressure of said vapor in said deposition zone is between about $1.33 \times 10^{-2}$ Pa and atmospheric.

13. The method according to any of Claims 1 to 12 wherein the substrate temperature is between about 50° and 200°C.

14. The method according to Claim 1 wherein the wavelength of said ultraviolet light is between about 190 to 260 nm.

15. The method according to Claim 1 wherein said substrate is selected from the group consisting of Si, Ge, GaAs, SiO$_2$ and Al$_2$O$_3$.

16. A method according to Claim 1 and/or 14 wherein said ultraviolet light is provided by a laser.

## Patentansprüche

1. Ein Verfahren zum Abscheiden von GaAs auf einer Substratoberfläche, die folgenden Schritte umfassend:

Anordnen des Substrates in einer Umgebung mit einer Atmosphäre, welche im wesentlichen feuchtigkeits- und sauerstofffrei ist;

in Kontakt bringen besagten Substrates mit einem Dampf bestehend aus einem flüchtigen Gallium-Arsen-Komplex, ausgewählt aus der Gruppe de Komplexe mit der Formel X$_3$GaAsR$_3$, wobei X Methyl oder Trifluormethyl ist und R Wasserstoff, Methyl oder Trifluormethyl ist, so daß besagter Dampf das Substrat berührt, welches auf eine Temperatur erwärmt werden kann, die 400°C nicht überschreitet, um thermische Zersetzung des Komplexes zu verhindern und;

Bestrahlen besagten Dampfes mit ultraviolettem Licht mit einer Wellenlänge und einer Intensität auf oder bei besagter Substratoberfläche, die ausreichen, um besagten Gallium-Arsen-Komplex photochemisch in besagtem Dampf zu Galliumarsenid umzuwandeln, um dadurch Galliumarsenidabscheidung auf besagter Substratoberfläche zu schaffen.

2. Das Verfahren nach Anspruch 1, wobei X Methyl ist.

3. Das Verfahren nach Anspruch 2, wobei R Methyl ist.

4. Das Verfahren nach Anspruch 2, wobei Trifluormethyl ist.

5. Das Verfahren nach Anspruch 2, wobei R Wasserstoff ist.

6. Das Verfahren nach Anspruch 1, wobei X Trifluormethyl ist.

7. Das Verfahren nach Anspruch 6, wobei R Wasserstoff ist.

8. Das Verfahren nach Anspruch 6, wobei R Methyl ist.

9. Das Verfahren nach Anspruch 1, wobei R Wasserstoff ist.

10. Das Verfahren nach Anspruch 1, wobei R Methyl ist.

11. Das Verfahren nach Anspruch 1, wobei R Trifluormethyl ist.

12. Das Verfahren nach Anspruch 1, wobei der Druck besagten Dampfes in besagter Abscheidungszone zwischen ungefähr $1,33 \times 10^{-2}$ Pa und Atmosphärendruck liegt.

13. Das Verfahren nach irgendeinem der Ansprüche 1—12, wobei die Substrattemperatur zwischen ungefähr 50° und 200°C liegt.

14. Das Verfahren nach Anspruch 1, wobei die Wellenlänge besagten ultravioletten Lichtes zwischen ungefähr 190 bis 260 nm liegt.

15. Das Verfahren nach Anspruch 1, wobei besagtes Substrat ausgewählt wird aus der Gruppe bestehend aus Si, Ge, GaAs, SiO$_2$ und Al$_2$O$_3$.

16. Ein Verfahren nach Anspruch 1 und/oder 14, wobei besagtes ultraviolettes Licht durch einen Laser zur Verfügung gestellt wird.

## Revendications

1. Procédé pour déposer du GaAs sur la surface d'un substrat, comprenant les étapes consistant:

à placer ledit substrat dans un milieu ayant une atmosphère qui est pratiquement dépourvue d'humidité et d'oxygène;

à mettre en contact ledit substrat avec une vapeur consistant en un complexe volatil de gallium et d'arsenic choisi dans le groupe de complexes répondant à la formule X$_3$GaAsR$_3$, dans laquelle X représente un groupe méthyle ou trifluorométhyle, et R représente l'hydrogène, un groupe méthyle ou trifluorométhyle, de sorte que ladite vapeur entre en contact avec le substrat qui peut être chauffé à une température n'excédant pas 400°C afin d'empêcher la décomposition thermique du complexe; et

à irradier ladite vapeur avec une lumière ultraviolette de longueur d'onde suffisante et d'intensité suffisante au niveau ou à proximité de la surface dudit substrat pour soumettre à une transformation photochimique ledit complexe gallium-arsenic dans ladite vapeur en arséniure de gallium afin de provoquer ainsi un dépôt d'arséniure de gallium sur la surface dudit substrat.

2. Procédé suivant la revendication 1, dans lequel X représente un groupe méthyle.

3. Procédé suivant la revendication 2, dans lequel R représente un groupe méthyle.

4. Procédé suivant la revendication 2, dans lequel il existe un groupe trifluorométhyle.

5. Procédé suivant la revendication 2, dans lequel R représente l'hydrogène.

6. Procédé suivant la revendication 1, dans lequel X représente un groupe trifluorométhyle.

7. Procédé suivant la revendication 6, dans lequel R représente l'hydrogène.

8. Procédé suivant la revendication 6, dans lequel R représente un groupe méthyle.

9. Procédé suivant la revendication 1, dans lequel R représente l'hydrogène.

10. Procédé suivant la revendication 1, dans lequel R représente un groupe méthyle.

11. Procédé suivant la revendication 1, dans lequel R représente un groupe trifluorométhyle.

12. Procédé suivant la revendication 1, dans lequel la pression de la vapeur dans la zone de déposition est comprise dans l'intervalle d'environ $1,33 \times 10^{-2}$ Pa à la pression atmosphérique.

13. Procédé suivant l'une quelconque des revendications 1 à 12, dans lequel la température du substrat est comprise dans l'intervalle d'environ 50° à 200°C.

14. Procédé suivant la revendication 1, dans lequel la longueur d'onde de la lumière ultraviolette est comprise dans l'intervalle d'environ 190 à 260 nm.

15. Procédé suivant la revendication 1, dans lequel le substrat est choisi dans le groupe comprenant Si, Ge, GaAs, $SiO_2$ et $Al_2O_3$.

16. Procédé suivant la revendication 1 et/ou la revendication 14, dans lequel la lumière ultraviolette est produite par un laser.